# EUROPÄISCHE PATENTSCHRIFT

(11) **EP 2 499 671 B1**
(45) Veröffentlichungstag und Bekanntmachung des Hinweises auf die Patenterteilung: **18.12.2019**
(21) Anmeldenummer: 11709671.9
(22) Anmeldetag: 09.03.2011
(51) Int. Cl.: H01L 27/32, H01L 51/52

(54) **ORGANISCHE LICHTEMITTIERENDE VORRICHTUNG MIT HOMOGENER LEUCHTDICHTEVERTEILUNG**
ORGANIC LIGHT-EMITTING DEVICE HAVING HOMOGENOUS BRIGHTNESS DISTRIBUTION
DISPOSITIF ÉMETTEUR DE LUMIÈRE ORGANIQUE À RÉPARTITION HOMOGÈNE DE LA LUMINANCE

(30) Priorität: 22.03.2010 DE 102010003121
(43) Veröffentlichungstag der Anmeldung: 19.09.2012
(73) Patentinhaber: OSRAM OLED GmbH, 93049 Regensburg (DE)
(72) Erfinder: INGLE, Andrew, 85391 Allershausen (DE); KRUMMACHER, Benjamin Claus, 93051 Regensburg (DE); LANG, Erwin, 93051 Regensburg (DE)
(74) Vertreter: Paul, Benjamin
(86) Internationale Anmeldenummer: PCT/EP2011/053522
(87) Internationale Veröffentlichungsnummer: WO 2011/117073

(56) Entgegenhaltungen:
- EP-A2- 1 679 939
- WO-A1-2008/062645
- WO-A1-2009/025286
- DE-A1-102006 055 884
- US-A1- 2005 270 454

## Beschreibung

Die vorliegende Erfindung betrifft eine organische optoelektronische Vorrichtung.

Eine organische lichtemittierende Vorrichtung (*organic light emitting device* bzw. OLED) ist ein Lumineszenzstrahler, mit dem aus elektrischer Energie eine elektromagnetische Strahlung erzeugt wird. Sie weist zumindest eine organische aktive Schicht auf, in der die elektromagnetische Strahlung entsteht. Die aktive Schicht ist zwischen einer Anode und einer Kathode angeordnet. Bei einem angelegten Durchlasspotential injiziert die Anode als Ladungsträger Löcher in die aktive Schicht, während die Kathode als Ladungsträger Elektronen injiziert. Die injizierten Löcher und Elektronen wandern jeweils (unter dem Einfluss eines extern angelegten elektrischen Felds) zu der entgegengesetzt geladenen Elektrode und erzeugen bei Rekombination in der aktiven Schicht eine elektrolumineszente Emission.

Eine OLED hat insbesondere den Vorteil, dass sie als großflächige Lichtquelle eingesetzt werden kann. Dazu sollte die OLED im Betrieb eine möglichst homogene Helligkeits-(Leuchtdichten-)verteilung über der aktiven Schicht aufweisen.

Ein Beleuchtungssystem mit einer hohen Leuchthomogenität ist aus den Dokumenten US 2005/0270464 A1, WO 2008/062645 A1 und WO 2009/025286 A1 bekannt.

Das Dokument US 2005/0270464 A1 beschreibt ein Beleuchtungssystem das eine erste Elektrode und eine zweite Elektrode aufweist. Zwischen den Elektroden ist eine Schicht mit einer lichtemittierenden Substanz ausgebildet. Eine dritte Elektrode ist ausgebildet, um die erste Elektrode durch eine in in der zweiten Elektrode und der Schicht ausgebildete Öffnung ausgebildet ist.

Der vorliegenden Erfindung liegt das Problem zugrunde, eine organische lichtemittierende Vorrichtung anzugeben, bei der eine möglichst homogene Leuchtdichtenverteilung erzielt wird.

Dieses Problem wird durch eine organische lichtemittierende Vorrichtung gemäß Patentanspruch 1 gelöst.

Weiterbildungen und vorteilhafte Ausgestaltungen der organischen lichtemittierenden Vorrichtung sind in den abhängigen Patentansprüchen angegeben.

Die EP 1 679 939 A2 beschreibt ein elektrolumineszentes Element, bei dem ein Widerstand eines Anschlusses positionsabhängig variiert, um eine Helligkeitsverteilung des elektrolumineszenten Elements zu beeinflussen, beispielsweise um eine möglichst homogene Helligkeitsverteilung bereitzustellen.

Der vorliegenden Erfindung liegt das Problem zugrunde, alternativ dazu eine organische lichtemittierende Vorrichtung anzugeben, bei der eine möglichst homogene Leuchtdichtenverteilung erzielt wird.

Dieses Problem wird durch eine organische lichtemittierende Vorrichtung gemäß Patentanspruch 1 gelöst.

Weiterbildungen und vorteilhafte Ausgestaltungen der organischen lichtemittierenden Vorrichtung sind in den abhängigen Patentansprüchen angegeben.

### BEISPIELHAFTE AUSFÜHRUNGSFORMEN

Die erfindungsgemäße organisch lichtemittierende Vorrichtung hat eine aktive Schicht zum Erzeugen einer Strahlung mit einer ersten Seitenfläche und einer an einer Eckkante angrenzenden zweiten Seitenfläche. Entlang der ersten Seitenfläche erstreckt sich eine erste Kontaktleiste zur Injektion von Ladungsträger eines ersten Typs in die aktive Schicht. Entlang der zweiten Seitenfläche erstreckt sich eine zweite Kontaktleiste zur Injektion von Ladungsträger eines zweiten Typs in die aktive Schicht. Die erste Seitenfläche weist einen an die Eckkante angrenzenden Rücknahmebereich auf. Im Rücknahmebereich ist die Injektion von Ladungsträgern aus der ersten Kontaktleiste unterdrückt.

Damit wird in Bereichen der organischen lichtemittierenden Vorrichtung, in den sich die Kontaktleisten zur Zuführung der Ladungsträger sehr nahe kommen, die Injektion von Ladungsträgern in die aktive Schicht begrenzt. Der daraus resultierende begrenzte Ladungsträgerstrom in der aktiven Schicht führt insgesamt zu einer Begrenzung von Rekombination in Bereichen, die ansonsten eine stark erhöhte Ladungsträgerdichte aufweisen würden. Im Ergebnis ist die Leuchtdichte in diesen Bereichen in etwa in der gleichen Größenordnung wie in anderen Bereichen der aktiven Schicht. Damit wird eine besonders homogene Leuchtdichtenverteilung erzielt. Die organische lichtemittierende Vorrichtung lässt sich vorzugsweise als großflächige, homogen ausgeleuchtete Lichtquelle verwenden. Sie ist damit insbesondere für Anwendung geeignet, die eine flächige Lichtquelle benötigen.

In einigen Ausführungsformen ist die erste Kontaktleiste nur außerhalb des Rücknahmebereichs mit der ersten Seitenfläche elektrisch kontaktiert. Damit wird eine Unterdrückung der Ladungsträgerinjektion entlang des Rücknahmebereichs erzielt.

In einigen Ausführungsformen ist die Injektion von Ladungsträgern aus der ersten Kontaktleiste im Rücknahmebereich vollständig unterdrückt. Die Ladungsträgerinjektion erfolgt nunmehr über andere Anschlussregionen, bspw. über Hauptseiten der aktiven Schicht oder bereits durch einen Ladungsträgerstrom durch die aktive Schicht. Damit wird eine besonders starke Begrenzung des Ladungsträgerstroms bewirkt.

In einigen Ausführungsformen ist entlang des Rücknahmebereichs ein Spalt zwischen der ersten Kontaktleiste und der aktiven Schicht gebildet. Damit wird eine besonders gute elektrische Isolation zwischen der ersten Kontaktleiste und dem Rücknahmebereich der Seitenfläche erhalten. Infolge dessen kann beispielsweise eine vollständige Unterdrückung der Ladungsträgerinjektion erhalten werden.

In einigen Ausführungsformen weist die zweite Seitenfläche einen an die Eckkante angrenzenden zweiten Rücknahmebereich auf, und die Injektion von Ladungsträgern aus der zweiten Kontaktleiste ist im zweiten Rücknahmebereich vollständig unterdrückt. Damit erfolgt eine Unterdrückung der Ladungsträgerinjektion an der Eckkante von Seiten beider Elektroden, d.h. sowohl für die Kathode als auch von der Anode. Diese Maßnahme erlaubt eine zusätzliche Kontrolle über den Ladungsträgerstrom und begrenzt zudem einen unerwünschten Ladungsträgertransport durch die aktive Schicht.

Gemäß der Erfindung weist die aktive Schicht eine erste Hauptfläche und eine zweite Hauptfläche auf. Ein die erste Kontaktleiste umfassender erste Kontaktanschluss erstreckt sich auf der ersten Hauptfläche. Ein die zweite Kontaktleiste umfassender zweite Kontaktanschluss erstreckt sich auf der zweiten Hauptfläche. Damit erfolgt eine Ladungsträgerinjektion nicht allein über die Kontaktleisten sondern auch über die Hauptseiten der aktiven Fläche.

Gemäß der Erfindung weist der erste Kontaktanschluss ein Leitfähigkeitsprofil auf, wobei die Leitfähigkeit von einer Mitte der ersten Seitenfläche hin zum Rücknahmebereich abnimmt. Damit kann durch die Gestaltung der von dem Kontaktanschluss ausgehenden Feldlinien die Ladungsträgerinjektion weiter beeinflusst werden. Insbesondere können große Feldgradienten am Übergang zum Rücknahmebereich vermieden werden, so dass ein besonders homogenes Leuchtbild der organischen lichtemittierenden Vorrichtung erzielt wird.

In einigen Ausführungsformen weist der erste Kontaktanschluss ein leitfähiges Oxid auf, beispielsweise ein Zinnoxid. Dabei ist der erste Kontaktanschluss insbesondere eine transparente Elektrode.

In einigen Ausführungsformen weist der erste Kontaktanschluss ein Metall oder eine Metalllegierung auf. Metall ist ein besonders guter elektrischer Leiter. Vorzugsweise ist das Metall in Bereichen außerhalb der Ausstrahlrichtung der organischen lichtemittierenden Vorrichtung vorgesehen. So kann das Metall insbesondere in der ersten Kontaktleiste seitlich der ersten Seitenfläche vorgesehen sein.

In einigen Ausführungsformen weist der erste Kontaktanschluss eine erste Flächenleitfähigkeit auf und der zweite Kontaktanschluss weist eine zweite Flächenleitfähigkeit auf. Dabei unterscheiden sich die erste Flächenleitfähigkeit und die zweite Flächenleitfähigkeit höchstens um einen Faktor 10. Solange die Flächeleitfähigkeiten beider Kontaktanschlüsse in der gleichen Größenordnung liegen, werden mit der beschrieben technischen Lösungen besonders homogene Leuchtdichten erzielt. Dies gilt umso mehr, wenn neben dem Rücknahmebereich auch ein zweiter Rücknahmebereich vorgesehen ist. Andernfalls kann nahe der Eckkante über die Größen der Rücknahmebereiche die Ladungsträgerinjektion beeinflusst werden. So kann auch bei abweichenden Größenordnungen der Flächenleitfähigkeit eine gute Leuchtdichtenhomogenität erzielt werden.

In einigen Ausführungsformen ist die organische lichtemittierende Vorrichtung als transparente OLED ausgestaltet.

In einigen Ausführungsformen ist die organische lichtemittierende Vorrichtung als bottom-emitter OLED ausgestaltet ist.

### KURZE BESCHREIBUNG DER ZEICHNUNGEN

Verschiedene Konfigurationen einer organisch lichtemittierenden Vorrichtung werden im Folgenden anhand der Zeichnungen näher erläutert. In den Figuren geben die erste(n) Ziffer(n) eines Bezugszeichens die Figur an, in denen das Bezugzeichen zuerst verwendet wird. Die gleichen Bezugszeichen werden für gleichartige oder gleich wirkende Elemente bzw. Eigenschaften in allen Figuren verwendet.

Es zeigen:
- **Fig. 1**: eine schematische Darstellung einer Aufsicht auf eine nicht erfindungsgemäße organische lichtemittierende Vorrichtung;
- **Fig. 2**: eine schematische Darstellung eines Längsschnitts durch die in der **Fig. 1** dargestellte organische lichtemittierende Vorrichtung entlang einer Schnittlinie A - A;
- **Fig. 3**: eine schematische Darstellung eines Querschnitts durch die in der **Fig. 1** dargestellte organische lichtemittierende Vorrichtung entlang einer Schnittlinie B - B;
- **Fig. 4**: eine schematische Darstellung eines vertikalen Flächenschnitts durch die in der **Fig. 1** dargestellte organische lichtemittierende Vorrichtung auf Höhe der metallischen Kontaktschicht;
- **Fig. 5**: eine schematische Darstellung einer Leuchtdichtenverteilung der in der **Fig. 1** dargestellten organischen lichtemittierenden Vorrichtung;
- **Fig. 6**: eine schematische Darstellung einer Aufsicht auf eine organische lichtemittierende Vorrichtung gemäß einer ersten Konfiguration, die nicht erfindungsgemäß ist;
- **Fig. 7**: eine schematische Darstellung eines vertikalen Flächenschnitts durch die in organische lichtemittierende Vorrichtung gemäß der ersten Konfiguration;
- **Fig. 8**: eine schematische Darstellung einer Leuchtdichtenverteilung der organischen lichtemittierenden Vorrichtung gemäß der ersten Konfiguration;
- **Fig. 9**: eine schematische Darstellung einer Aufsicht auf eine organische lichtemittierende Vorrichtung gemäß einer zweiten Konfiguration, die ein erfindungsgemäßes Ausführungsbeispiel ist;
- **Fig. 10**: eine schematische Darstellung eines vertikalen Schnitts durch die organische lichtemittierende Vorrichtung gemäß dem Ausführungsbeispiel;
- **Fig. 11**: eine schematische Darstellung eines vertikalen Schnitts durch eine Variante der organischen lichtemittierenden Vorrichtung;
- **Fig. 12**: eine schematische Darstellung einer Leuchtdichtenverteilung der organisch lichtemittierenden Vorrichtung;
- **Fig. 13**: eine schematische Darstellung eines vertikalen Schnitts durch eine organische lichtemittierende Vorrichtung gemäß einer dritten Konfiguration, die nicht erfindungsgemäß ist;
- **Fig. 14**: eine schematische Darstellung eines vertikalen Schnitts durch eine organische lichtemittierende Vorrichtung gemäß einer vierten Konfiguration, die nicht erfindungsgemäß ist, und
- **Fig. 15**: eine schematische Darstellung eines vertikalen Schnitts durch eine organische lichtemittierende Vorrichtung gemäß einer fünften Konfiguration.

### DETAILLIERTE BESCHREIBUNG DER ZEICHNUNGEN

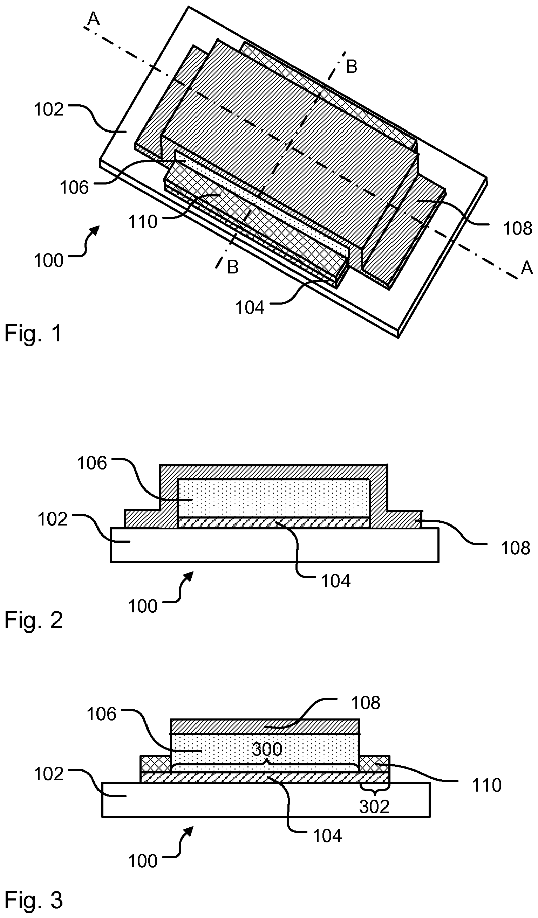

Die **Fig. 1** zeigt eine schematische Darstellung einer Aufsicht auf eine organische lichtemittierende Vorrichtung 100. Die organische lichtemittierende Vorrichtung 100 weist ein Substrat 102 auf. Das Substrat 102 ist ein transparentes Material, beispielsweise ein Glas, Quarz oder eine Polymerfolie. Auf dem Substrat 102 ist flächig eine transparente Kontaktschicht 104 aufgebracht, die Teil eines ersten Kontaktanschlusses ist. Die transparente Kontaktschicht 104 weist ein transparentes, leitfähiges Material auf. Dies kann beispielsweise ein transparentes, leitendes Oxid (*transparent conductive oxide* bzw. TCO) sein. Das TCO ist in der Regel ein Metalloxid, beispielsweise Zinkoxid, Zinnoxid, Cadmiumoxid, Titanoxid, Indiumoxid oder Indiumzinnoxid (ITO). Neben binären Metallstoffverbindungen, wozu auch SnO₂ und In₂O₃ zählen, gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder auch Mischungen unterschiedlicher transparenter leitender Oxide zu der Gruppe der TCO. Weiterhin entsprechen die TCO nicht zwingend einer stöchiometrischen Zusammensetzung und können auch p- oder n-dotiert sein, um eine hohe Leitfähigkeit zu erzielen.

Auf der transparenten Kontaktschicht 104 ist eine aktive Schicht 106 aufgebracht, in der elektromagnetische Strahlung erzeugt werden kann. Dazu weist die aktive Schicht 106 eine Funktionsschicht mit einem elektrolumineszenten Material auf. Beispielsweise kann das elektrolumineszente, organische Material geeignete Polymere für eine Fluoreszenz- oder eine Phosphoreszenzemission aufweisen. Alternativ können kleine organische Moleküle, die über Fluoreszenz oder über Phosphoreszenz emittieren, als organische Elektrolumineszenzschicht dienen. Neben der Funktionsschicht kann die aktive Schicht 106 auch weitere Schichten, beispielsweise eine Ladungsträgertransportschicht, aufweisen.

Die **Fig. 2** zeigt eine schematische Darstellung eines Längsschnitts durch die in der **Fig. 1** dargestellten organischen lichtemittierenden Vorrichtung entlang der Schnittlinie A - A. Die **Fig. 2** zeigt, dass die aktive Schicht 106 über der transparenten Kontaktschicht 104 aufgebracht ist. Allgemein hat die Kontaktschicht 104 eine erste Hauptseite, auf der sie auf der Kontaktschicht 104 aufliegt, und eine zweite Hauptseite, die von einem zweiten Kontaktanschluss 108 bedeckt ist. Zusätzlich weist die aktive Schicht 106 in der gezeigten Konfiguration vier Seitenflächen auf, von denen die beiden, sich gegenüberliegenden, kürzeren Seitenflächen von dem zweiten Kontaktanschluss 108 bedeckt sind. Der zweite Kontaktanschluss 108 ragt entlang beider kurzen Seitenflächen auf das Substrat 102, so dass er je eine Kontaktleiste entlang der beiden kurzen Seitenflächen bildet.

Die beiden, sich gegenüberliegenden, längeren Seitenflächen grenzen an einen jeweils von der aktiven Schicht 106 freigelassenen Bereich der transparenten Kontaktschicht 104. Dies wird in Bezug auf **Fig. 3** deutlich. **Fig. 3** zeigt eine schematische Darstellung eines Querschnitts durch die in der **Fig. 1** dargestellte organische lichtemittierende Vorrichtung entlang der Schnittlinie B - B. Dargestellt ist das Substrat 102 auf dem die transparente Kontaktschicht 104 aufgebracht ist. Die transparente Kontaktschicht 104 ist in einem großflächigen Bedeckungsbereich 300 von der ersten Hauptseite der aktiven Schicht 106 bedeckt. Daneben weist sie freigelassene Bereiche, bspw. auf der rechten Seite einen freigelassenen Bereich 302 auf. Die aktive Schicht 106 ist mit dem zweiten Kontaktanschluss 108 bedeckt.

Auf dem freigelassenen Bereich 302 ist eine metallische Kontaktschicht 110 aufgebracht, so dass die transparente Kontaktschicht 104 und die metallische Kontaktschicht 110 eine erste Kontaktleiste des ersten Kontaktanschlusses bilden. Die metallische Kontaktschicht 110 muss nicht notwendigerweise auf der transparenten Kontaktschicht 104 angeordnet sein. Grundsätzlich ist ihre Verwendung optional. Ebenso wäre es beispielsweise denkbar, dass die metallische Kontaktschicht 110 unterhalb der transparenten Kontaktschicht 104 angeordnet ist oder von dieser umschlossen ist. Sie bietet den Vorteil einer besonders hohen Ladungsträgerleitfähigkeit. Die auch im Folgenden dargestellte Anordnung der metallischen Kontaktschicht 110 oberhalb der transparenten Kontaktschicht 104 hat unter anderem den Vorteil, dass sich diese Schichtabfolge leicht herstellen lässt.

Der erste Kontaktanschluss dient zur Injektion eines ersten Typs von Ladungsträgern in die aktive Schicht 106. Diese Ladungsträger können beispielsweise Löcher sein. Der erste Kontaktanschluss ist in diesem Fall eine Anode. Sie weist üblicherweise ein ITO mit einer Flächenleitfähigkeit von ca. 15 Ω/sq. Der zweite Kontaktanschluss 108 dient zur Injektion eines zweiten Typs von Ladungsträgern. Diese Ladungsträger weisen eine andere Polarität als die Ladungsträger des ersten Typs auf, sie sind beispielsweise Elektronen. Der zweite Kontaktanschluss 108 ist in diesem Fall eine Kathode. Eine transparente Kathode hat üblicherweise einen Flächenwiderstand von ca. 5 Q/sq.

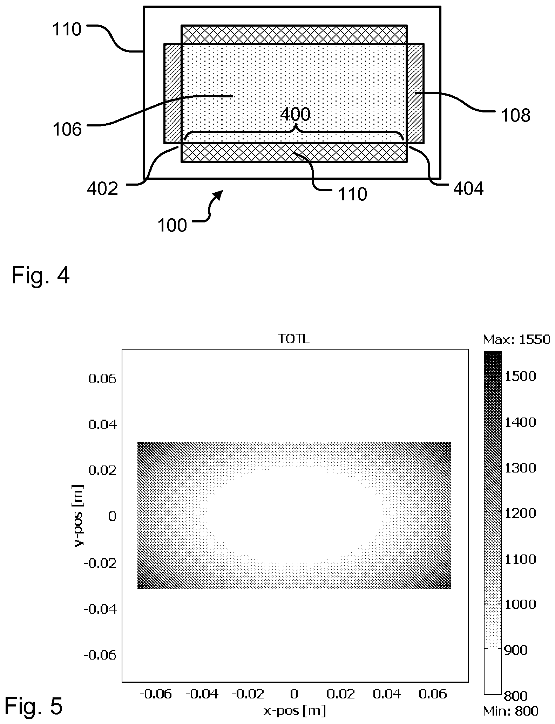

Die räumliche Anordnung der Kontaktleisten des ersten Kontaktanschlusses und des zweiten Kontaktanschlusses 108 wird nachfolgend anhand der **Fig. 4** genauer beschrieben. Die **Fig. 4** zeigt eine schematische Aufsicht eines vertikalen Flächenschnitts durch die in der **Fig. 1** dargestellte organische lichtemittierende Vorrichtung auf Höhe der metallischen Kontaktschicht 110. Über dem Substrat 102 sind die aktive Schicht 106 sowie die Kontaktleisten des zweiten Kontaktanschlusses 110 dargestellt. Die aktive Schicht 106 hat zwei kürzere Seitenflächen, die an die Kontaktleisten des zweiten Kontaktanschlusses 108 grenzen. Daneben hat die aktive Schicht 106 zwei sich gegenüberliegende, längere Seitenflächen, die an die metallische Kontaktschicht 110 grenzen. Die metallische Kontaktschicht 110 erstreckt sich entlang einer ersten längeren Seitenfläche 400 und kontaktiert diese vollständig von einer ersten Eckkante 302 bis zu einer zweiten Eckkante 404. Auch der zweite Kontaktanschluss 110 grenzt unmittelbar an die erste Eckkante 402 und die zweite Eckkante 404.

Die Kontaktleisten des ersten Kontaktanschluss und der zweite Kontaktanschluss 108 befinden im Bereich der Ecckanten, bspw. der ersten Eckkante 402 und der zweiten Eckkante 404, nahe aneinander. Bei Anlegen einer Spannung bündeln sich in diesem Bereich die Feldlinien eines zwischen den Kontaktleisten angelegten elektrischen Feldes. Dabei besteht zwischen dem Feld *E* und einer angelegten Spannung *V* der folgende Zusammenhang: *E* = -grad *V*.

Die aktive Schicht 106 weist ein nicht-ohmsches Verhalten auf. Das bedeutet, dass zwischen einer an der aktiven Schicht 106 angelegten Spannung (*V*) und einem durch die Funktionsschicht fließenden Flächenstrom (*j(x,y)*) kein linearer Zusammenhang besteht. Weist die aktive Schicht 106 beispielsweise einen pn-Übergang auf, so entspricht ihr Verhalten einer Diode, log(*j(x,y)*) *α V*.

Bei einer organischen Lumineszenzdiode weist die aktive Schicht 106 beispielsweise ein organisches Elektrolumineszenzmaterial auf, das bei Anlegen einer Spannung, bzw. eines Potentials, Licht emittiert. Das organische Elektrolumineszenzmaterial ist beispielsweise ein Polymer. Es können auch kleine organische Moleküle, die über Fluoreszenz oder über Phosphoreszenz emittieren, als organisches Elektrolumineszenzmaterial dienen. In diesem Fall erfolgt ein Ladungsträgertransport über Hüpf- oder Tunnelprozesse. Der Zusammenhang zwischen angelegter Spannung (*V*) und durch die aktive Schicht 106 fließendem Strom (*j(x,y)*) lässt sich entsprechend der Strom-Spannungs-Charakteristik einer Elektronenröhre beschreiben, d.h. *j(x,y)* α *V*²/³.

Durch die hohe Felddichte entstehen in Bereichen der aktiven Schicht 106 nahe der ersten Eckkante 402 und der zweiten Eckkante 404 hohe Flächenströme im Verhältnis zu Flächenströmen in anderen Bereichen der aktiven Schicht 106. Eine durch den Flächenstrom *j(x,y)* hervorgerufen Leuchtdichte *L* der aktiven Schicht 106 ist direkt proportional zu dem Flächenstrom: *L α j(x,y).* Damit wird im Bereich der ersten Eckkante 402 und der zweiten Eckkante 404 eine höhere Leuchtdichte erzielt, als in anderen Bereichen der aktiven Schicht 106. Das so entstehende Leuchtbild wird anhand der **Fig. 5** deutlich.

Die **Fig. 5** zeigt eine schematische Darstellung einer Leuchtdichtenverteilung der in der **Fig. 1** bis **Fig. 4** dargestellten organischen lichtemittierenden Vorrichtung. Die schematische Darstellung beruht auf einer Simulation der Leuchtdichtenverteilung.

Dabei ist in Form von Graustufen die Leuchtdichtenverteilung in cd/m² auf einer Strahlungsauskopplungsoberfläche der organischen lichtemittierenden Vorrichtung dargestellt. Die Abszisse (X-Achse) gibt dabei die Erstreckung zwischen den Kontaktleisten des zweiten Kontaktanschluss 108 auf der linken Seite und der rechten Seite wieder. Die Ordinate (Y-Achse) gibt eine Erstreckung längs der Kontaktleisten des ersten Kontaktanschlusses wieder (vgl. mit der Darstellung in der **Fig. 3**). Die Simulation lässt erkennen, dass die Leuchtdichte in Mitte zwischen den Anschlüssen geringer ist, als in Nähe einer der ersten Eckkante 402 und der zweiten Eckkante 404. Dabei variiert die Leuchtdichte zwischen ca. 800 cd/m² im Zentralbereich der aktiven Schicht 106 und ca. 1500 cd/m² im Bereich der Eckkanten. Die Skalen der Ausdehnung und der Leuchtdichte sind für die Simulation gewählt und sind daher nur als beispielhaft zu verstehen. Jedoch wird die große Varianz der Leuchtdichte deutlich.

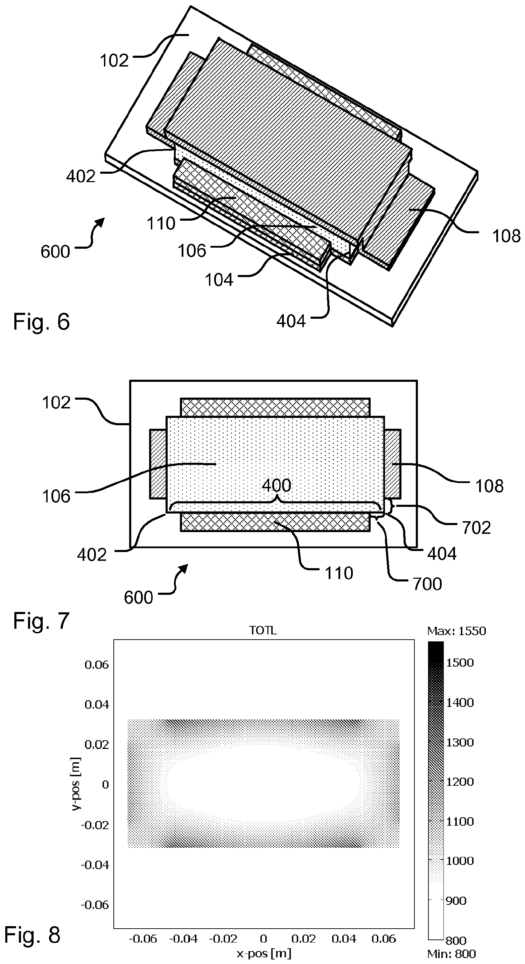

Die **Fig. 6** zeigt eine schematische Darstellung einer Aufsicht auf eine organische lichtemittierende Vorrichtung 600 gemäß einer ersten Konfiguration. Die organische lichtemittierende Vorrichtung 600 unterscheidet sich von der unter Bezug auf die **Fig. 1** bis **Fig. 4** dargestellten organischen lichtemittierenden Vorrichtung 100 dadurch, dass die Kontaktleisten des ersten Kontaktanschlusses und des zweiten Kontaktanschlusses 108 im Bereich der ersten Eckkante 402 und der zweiten Eckkante 404 von den Seitenkanten der aktiven Schicht 106 zurückgenommen sind. Dies wird besonders deutlich mit Blick auf die **Fig. 7****.**

Die **Fig. 7** zeigt eine schematische Darstellung eines vertikalen Flächenschnitts durch die organische lichtemittierende Vorrichtung 600 gemäß der ersten Konfiguration auf Höhe der metallischen Kontaktschicht 110. Über den Substrat 102 sind die aktive Schicht 106 sowie Bereiche des zweiten Kontaktanschlusses 108 an den kürzeren Seiten der aktiven Schicht 106 dargestellt. An den längeren Seiten erstreckt sich die metallische Kontaktschicht 110. Sie bedeckt dabei die Seitenfläche 400, die zwischen einer erste Eckkante 302 und einer zweiten Eckkante 404 verläuft. Im Bereich der zweiten Eckkante 404 befindet sich ein Rücknahmebereich 700 der frei von metallischen Kontaktschicht 110 ist. In dem Rücknahmebereich 700 ist die Seitenfläche 400 elektrisch nicht mit dem ersten Kontaktanschluss verbunden. Eine Injektion von Ladungsträgern aus dem ersten Kontaktanschluss über den Rücknahmebereich 700 in die aktive Schicht 106 ist damit vollständig unterbunden. In der angrenzenden Region der aktiven Fläche 106 erfolgt eine Injektion der Ladungsträger weitgehend über die unter der aktiven Schicht 106 liegende transparente Kontaktschicht 104, die in **Fig. 5** zu erkennen ist.

Die Größe des Rücknahmebereichs 700 kann sich je nach Bedarf gewählt werden. Er kann mehr als 2,5% der Seitenfläche 400 einnehmen. Typischweise wird er ca. 10% der Seitenfläche 400 einnehmen, so dass die Seitenfläche 400 an ca. 80% der Erstreckung die metallische Kontaktschicht 110 kontaktiert.

Durch die Unterdrückung der Ladungsträgerinjektion im Rücknahmebereich 700 wird der durch die an die zweite Eckkante 404 angrenzende Region der aktiven Fläche 106 fließende Ladungsträgerstrom begrenzt. Die erhöhte Leuchtdichte in diesem Bereich wird damit verringert, so dass im Vergleich zu der unter Bezug auf die **Fig. 1** bis **Fig. 4** dargestellten organische lichtemittierenden Vorrichtung 100 ein homogeneres Leuchtbild erhalten wird. Um diesen Effekt zu verstärken, ist auch der zweite Kontaktanschluss 108 an der zweiten Eckkante 404 zurückgenommen, so dass ein zweiter Rücknahmebereich 702 vorhanden ist, in dem keine Ladungsträger von dem zweiten Kontaktanschluss 108 über die Seitenfläche in die aktive Schicht 106 injiziert werden. Gleichwirkende Bereiche sind an allen Ecckanten der Seiteflächen der aktiven Schicht 106 vorgesehen. Damit sind an allen Eckkanten der injizierte Ladungsträgerstrom und dadurch auch die Leuchtdichte lokal begrenzt. Insgesamt wird so ein homogenes Leuchtbild erhalten. Dies wird anhand der **Fig. 8** deutlich, die eine schematische Darstellung einer Leuchtdichtenverteilung der ersten Konfiguration der organischen lichtemittierenden Vorrichtung zeigt. Dabei zeigt die **Fig. 8** ein zu der **Fig. 5** vergleichbares Leuchtbild, bei dem lediglich die Kontaktleisten gemäß der ersten Konfiguration angepasst sind. Zur besseren Vergleichbarkeit wurden für alle auch im Folgenden dargestellten Leuchtdichteverteilungen die Parameter dabei derart gewählt, dass jeweils über eine über der gesamten Leuchtfläche gemittelte Leuchtdichte von 1000 cd/m² erreicht wird. In der in **Fig. 8** dargestellten Leuchtdichteverteilung liegt die Leuchtdichte im Bereich der Eckkanten im wesentlichen in der Größenordnung der Leuchtdichte, die in weiten Bereichen der organischen lichtemittierenden Vorrichtung erhalten wird, d.h. bei ca. 900 cd/m² bis 1000 cd/m². Es wird insgesamt ein deutlich homogeneres Leuchtbild als in **Fig. 5** erzielt.

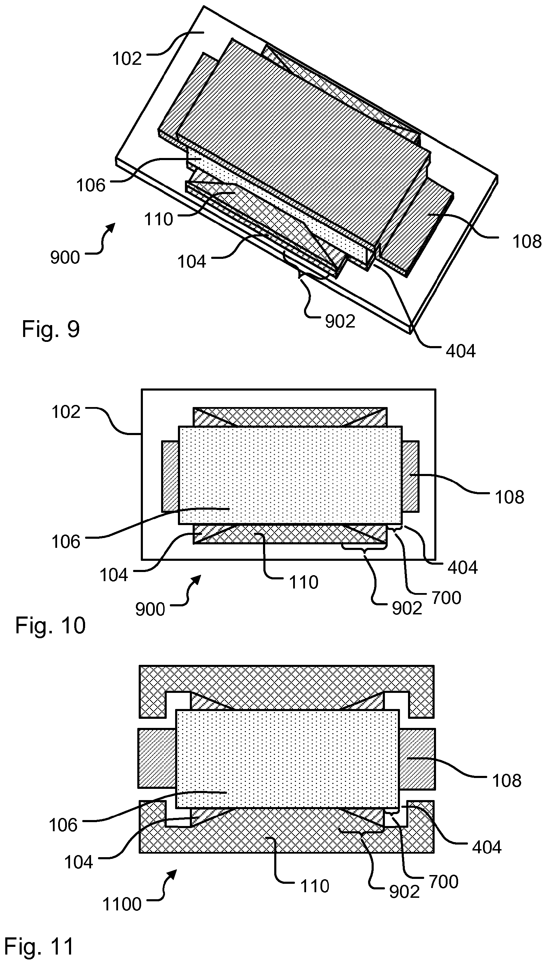

**Fig. 9** zeigt eine schematische Darstellung einer Aufsicht auf eine organische lichtemittierende Vorrichtung gemäß einer zweiten Konfiguration, die ein erfindungsgemäßes Ausführungsbeispiel ist. Dabei unterscheidet sich eine organische lichtemittierende Vorrichtung 900 gemäß dem Ausführungsbeispiel von einer organischen lichtemittierenden Vorrichtung 600 gemäß der ersten Konfiguration durch eine besondere Ausgestaltung der Kontaktleisten des ersten Kontaktanschlusses. In der organischen lichtemittierenden Vorrichtung 900 weist die metallische Kontaktschicht 110 in einem Randbereich 902 eine Dreieckstruktur auf. Dabei wird die metallische Kontaktschicht umso stärker von der Seitenfläche der aktiven Schicht 106 zurückgenommen, je näher sie an den Rücknahmebereich 700 kommt. Diese Struktur wird anhand der **Fig. 10** besonders deutlich. Die **Fig. 10** zeigt eine schematische Darstellung eines vertikalen Schnitts durch die organische lichtemittierende Vorrichtung 900 gemäß dem Ausführungsbeispiel. Es ist zu erkennen, dass im Randbereich 902 der Kontaktleiste des ersten Kontaktanschlusses ein Abstand zwischen der Seitenfläche 400 und der metallischen Kontaktschicht 110 hin zu dem Rücknahmebereich 700 linear zunimmt. Damit verringert sich in von der Mitte weg hin zu der zweiten Eckkante die Ladungsträgerleitfähigkeit der Kontaktleiste. Die Injektion von Ladungsträger wird entsprechend verringert.

Üblicherweise erstreckt sich der Rücknahmebereich 700 bei einem linearen Verlauf über ca. 40% der Kontaktleiste. Er kann jedoch auch größer oder kleiner gewählt werden. Er kann auch anders ausgestaltet sein, bspw. in einem parabolischen, konvexen oder auch konkaven Verlauf eines Rands der Kontaktleiste, wesentlich ist eine Abnahme der Leitfähigkeit der Kontaktleiste hin zu dem Rücknahmebereich 700. Damit können am Randbereich 902 der Kontaktleiste starke Feldgradienten in der aktiven Schicht 106 reduziert werden.

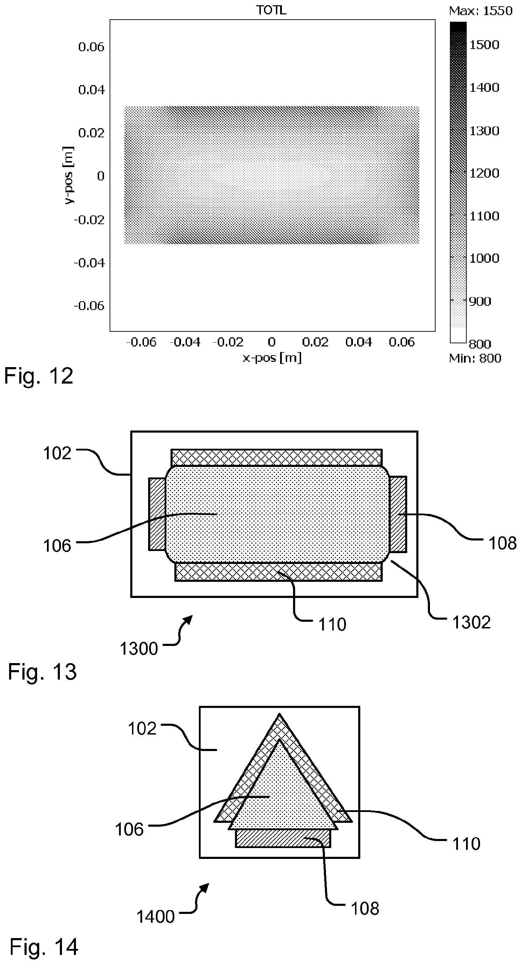

Die weitere Geometrie der metallischen Kontaktschicht 110 ist dabei unerheblich. So ist in **Fig. 11** eine Variante der organischen lichtemittierenden Vorrichtung gemäß dem Ausführungsbeispiel dargestellt. Diese zeigt eine metallische Kontaktschicht 110, die sich parallel zu dem Rücknahmebereich 700 erstreckt, an diesem aber nicht die aktive Schicht 106 kontaktiert. Vielmehr ist zwischen der Kontaktschicht 10 und der aktiven Schicht 106 entlang des Rücknahmebereichs ein Spalt ausgebildet, so dass eine elektrische Isolation erhalten wird. Im Ergebnis ist eine Ladungsträgerinjektion über die metallische Kontaktschicht 110 im Rücknahmebereich vollständig unterdrückt. Um ein homogenes Leuchtbild der organischen lichtemittierenden Vorrichtung zu erhalten, ist es wichtig, dass die Leitfähigkeit der Kontaktleiste von einer Mitte der lateralen Erstreckung der Kontaktleiste hin zu der Eckkante 404 abnimmt und vorzugzugweise in einem Rücknahmebereich 700 den Wert Null annimmt. Im Ergebnis ergibt sich ein homogenes Leuchtbild der organischen lichtemittierenden Vorrichtung gemäß dem Ausführungsbeispiel, wie es in **Fig. 12** dargestellt ist. Dabei zeigt die **Fig. 12** ein zu der **Fig. 8** vergleichbares Leuchtbild, bei dem lediglich die Kontaktleisten angepasst sind. Die Leuchtdichte im Bereich der Eckkanten liegt im wesentlichen in der Größenordnung der Leuchtdichte, die in weiten Bereichen der organischen lichtemittierenden Vorrichtung erhalten wird, d.h. bei 900 cd/m² bis 1000 cd/m². Auch sind an den Kontaktleisten keine besonders ausgestalteten Leuchtdichtengradienten erkennbar. Es wird insgesamt ein deutlich homogeneres Leuchtbild als in der **Fig. 5** oder in der **Fig. 8** erzielt.

**Fig. 13** zeigt eine schematische Darstellung eines vertikalen Schnitts durch eine organische lichtemittierende Vorrichtung gemäß einer dritten Konfiguration. Anhand der dritten Konfiguration einer organischen lichtemittierenden Vorrichtung 1300 wird verdeutlicht, dass es auch denkbar ist, dass die aktive Schicht 106 auch eine abgerundete Eckkante 1302 aufweisen kann. Wesentlich für die beschriebene technische Lösung ist es, dass im Bereich der Eckkanten, an der zwei Kontaktleisten aneinandergrenzen, ein Rücknahmebereich vorgesehen ist, in dem die Injektion von Ladungsträgern über die Kontaktleisten möglichst vollständig unterdrückt ist.

**Fig. 14** zeigt eine schematische Darstellung eines vertikalen Schnitts durch eine organische lichtemittierende Vorrichtung gemäß einer vierten Konfiguration. Anhand einer organischen lichtemittierenden Vorrichtung 1400 wird verdeutlicht, dass die Grundform der aktiven Schicht 106 unerheblich für die beschriebene technische Lösung ist. So kann neben einer dreieckigen und einer viereckigen Grundform auch jede andere geeignete Grundform gewählt werden.

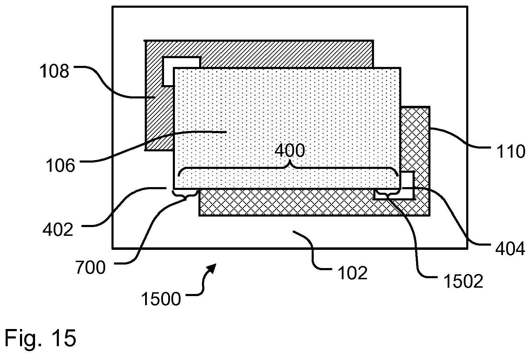

**Fig. 15** zeigt eine schematische Darstellung eines vertikalen Schnitts durch eine organische lichtemittierende Vorrichtung gemäß einer fünften Konfiguration. Eine dargestellte organische lichtemittierende Vorrichtung 1500 unterscheidet sich von den Vorrichtungen in den anderen beschriebenen Konfigurationen dadurch, dass wenigstens eine der Elektroden eine Kontaktleiste aufweist, die sich entlang zweier benachbarter Seitenkanten der aktiven Schicht 106 erstreckt. So sich die metallische Kontaktschicht 110 sowohl entlang der (unteren) Seitefläche 400 zwischen der ersten Eckkante 402 und der zweiten Eckkante 404. Dabei ist an der Seitenfläche 400 angrenzend an die erste Eckkante 402 der Rücknahmebereich 700 ausgebildet, wobei an der ersten Eckkante 402 die linke Seitenfläche angrenzt, entlang der sich der zweite Kontaktanschluss 108 erstreckt. Die metallische Kontaktschicht 110 erstreckt sich ebenfalls entlang der rechten Seitenfläche. Die aktive Schicht 106 wird somit sowohl an der unteren Seitenfläche 400 und der rechten Seitenfläche von dem zweiten Kontaktanschluss über die metallische Kontaktschicht 110 kontaktiert. Im Bereich des zweiten Eckpunktes 404 ist vorteilhafterweise ein dritter Rücknahmebereich 1502 vorgesehen, um eine elektrische Kontaktierung zwischen der metallischen Kontaktschicht 110 und der aktiven Schicht 106 zu verhindern. So werden hohe Feldliniengradienten im Bereich der zweiten Eckkante 404 vermieden.

### ABSCHLIESSENDE FESTSTELLUNG

Die organische lichtemittierende Vorrichtung wurde zur Veranschaulichung des zugrundeliegenden Gedankens anhand einiger Konfigurationen beschrieben. Die Konfigurationen sind dabei nicht auf bestimmte Merkmalskombinationen beschränkt. Auch wenn einige Merkmale und Ausgestaltungen nur im Zusammenhang mit einer besonderen Konfiguration oder einzelnen Konfigurationen beschrieben wurden, können sie jeweils mit anderen Merkmalen aus anderen Konfigurationen kombiniert werden. Es ist ebenso möglich, in Konfigurationen einzelne dargestellte Merkmale oder besondere Ausgestaltungen wegzulassen oder hinzuzufügen, soweit die allgemeine technische Lehre realisiert bleibt.

**BEZUGSZEICHENLISTE**

| | |
|---|---|
| Organische lichtemittierende Vorrichtung | 100 |
| Substrat | 102 |
| Transparente Kontaktschicht | 104 |
| Aktive Schicht | 106 |
| Zweiter Kontaktanschluss | 108 |
| Metallische Kontaktschicht | 110 |
| Bedeckungsbereich | 300 |
| Freigelassener Bereich | 302 |
| Seitenfläche | 400 |
| Erste Eckkante | 402 |
| Zweite Eckkante | 404 |
| Organische lichtemittierende Vorrichtung | 600 |
| Rücknahmebereich | 700 |
| Zweiter Rücknahmebereich | 702 |
| Organische lichtemittierende Vorrichtung | 900 |
| Randbereich | 902 |
| Organische lichtemittierende Vorrichtung | 1100 |
| Organische lichtemittierende Vorrichtung | 1300 |
| Abgerundete Eckkante | 1302 |
| Organische lichtemittierende Vorrichtung | 1400 |
| Organische lichtemittierende Vorrichtung | 1500 |
| Dritter Rücknahmebereich | 1502 |

## Patentansprüche

1. Organische lichtemittierende Vorrichtung umfassend:
- eine aktive Schicht (106) zum Erzeugen einer Strahlung mit einer ersten Seitenfläche (400) und einer an einer Eckkante (404) angrenzenden zweiten Seitenfläche,
- eine sich entlang der ersten Seitenfläche erstreckenden ersten Kontaktleiste zur Injektion von Ladungsträger eines ersten Typs in die aktive Schicht (106) und
- eine sich entlang der zweiten Seitenfläche erstreckenden zweiten Kontaktleiste zur Injektion von Ladungsträger eines zweiten Typs in die aktive Schicht (106),
wobei die erste Seitenfläche (400) einen an die Eckkante (404) angrenzenden Rücknahmebereich (700) aufweist, und die Injektion von Ladungsträgern aus der ersten Kontaktleiste im Rücknahmebereich (700) unterdrückt ist, wobei die aktive Schicht (106) eine erste Hauptfläche und eine zweite Hauptfläche aufweist, und sich ein die erste Kontaktleiste umfassender erste Kontaktanschluss auf die erste Hauptfläche und sich ein die zweite Kontaktleiste umfassender zweite Kontaktanschluss (108) auf der zweiten Hauptfläche erstreckt, **dadurch gekennzeichnet, dass** eine metallische Kontaktschicht (110) des ersten Kontaktanschlusses in einem Randbereich (902) eine Dreieckstruktur aufweist, wobei die metallische Kontaktschicht umso stärker von der Seitenfläche der aktiven Schicht (106) zurückgenommen wird, je näher sie an den Rücknahmebereich (700) kommt, so dass der erste Kontaktanschluss ein Leitfähigkeitsprofil aufweist, und die Leitfähigkeit von einer Mitte der ersten Seitenfläche (400) hin zum Rücknahmebereich (700) abnimmt.

2. Organische lichtemittierende Vorrichtung gemäß Patentanspruch 1, wobei die erste Kontaktleiste nur außerhalb des Rücknahmebereichs (700) mit der ersten Seitenfläche (400) elektrisch kontaktiert ist.

3. Organische lichtemittierende Vorrichtung gemäß einem der vorstehenden Patentansprüche, wobei die Injektion von Ladungsträgern aus der ersten Kontaktleiste im Rücknahmebereich (700) vollständig unterdrückt ist.

4. Organische lichtemittierende Vorrichtung gemäß einem der vorstehenden Patentansprüche, wobei entlang des Rücknahmebereichs (700) ein Spalt zwischen der ersten Kontaktleiste und der aktiven Schicht (106) gebildet ist.

5. Organische lichtemittierende Vorrichtung gemäß einem der vorstehenden Patentansprüche, wobei die zweite Seitenfläche einen an die Eckkante (404) angrenzenden zweiten Rücknahmebereich (702) aufweist, und die Injektion von Ladungsträgern aus der zweiten Kontaktleiste im zweiten Rücknahmebereich (702) vollständig unterdrückt ist.

6. Organische lichtemittierende Vorrichtung gemäß einem der vorstehenden Patentansprüche, wobei der erste Kontaktanschluss ein leitfähiges Oxid, beispielsweise ein Zinnoxid, aufweist.

7. Organische lichtemittierende Vorrichtung gemäß einem der vorstehenden Patentansprüche, wobei der erste Kontaktanschluss eine erste Flächenleitfähigkeit aufweist und der zweite Kontaktanschluss eine zweite Flächenleitfähigkeit aufweist und sich die erste Flächenleitfähigkeit und die zweite Flächenleitfähigkeit höchstens um einen Faktor 10 unterscheiden.

8. Organische lichtemittierende Vorrichtung gemäß einem der vorstehenden Patentansprüche, die als transparente OLED ausgestaltet ist.

9. Organische lichtemittierende Vorrichtung gemäß einem der vorstehenden Patentansprüche, die als bottom-emitter OLED ausgestaltet ist.

## Claims

1. Organic light-emitting device comprising:
- an active layer (106) for generating radiation having a first side surface (400) and a second side surface adjoining a corner edge (404),
- a first contact strip extending along the first side surface and serving for injecting charge carriers of a first type into the active layer (106), and
- a second contact strip extending along the second side surface and serving for injecting charge carriers of a second type into the active layer (106),
wherein the first side surface (400) has a cancellation region (700) adjoining the corner edge (404), and the injection of charge carriers from the first contact strip is suppressed in the cancellation region (700), wherein the active layer (106) has a first main surface and a second main surface, and a first contact connection comprising the first contact strip extends onto the first main surface and a second contact connection (108) comprising the second contact strip extends on the second main surface, **characterized in that** a metallic contact layer (110) of the first contact connection has a triangular structure in a marginal region (902), wherein the metallic contact layer is withdrawn from the side surface of the active layer (106) all the more, the nearer said metallic contact layer comes to the cancellation region (700), with the result that the first contact connection has a conductivity profile, and the conductivity decreases from a centre of the first side surface (400) towards the cancellation region (700).

2. Organic light-emitting device according to Patent Claim 1, wherein the first contact strip is electrically contacted with the first side surface (400) only outside the cancellation region (700).

3. Organic light-emitting device according to either of the preceding patent claims, wherein the injection of charge carriers from the first contact strip is completely suppressed in the cancellation region (700).

4. Organic light-emitting device according to any of the preceding patent claims, wherein along the cancellation region (700) a gap is formed between the first contact strip and the active layer (106).

5. Organic light-emitting device according to any of the preceding patent claims, wherein the second side surface has a second cancellation region (702) adjoining the corner edge (404), and the injection of charge carriers from the second contact strip is completely suppressed in the second cancellation region (702).

6. Organic light-emitting device according to any of the preceding patent claims, wherein the first contact connection comprises a conductive oxide, for example a tin oxide.

7. Organic light-emitting device according to any of the preceding patent claims, wherein the first contact connection has a first surface conductivity and the second contact connection has a second surface conductivity and the first surface conductivity and the second surface conductivity differ at most by a factor of 10.

8. Organic light-emitting device according to any of the preceding patent claims, which is configured as a transparent OLED.

9. Organic light-emitting device according to any of the preceding patent claims, which is configured as a bottom-emitter OLED.

## Revendications

1. Dispositif émetteur de lumière organique comportant :
- une couche active (106) pour la production d'un rayonnement avec une première surface latérale (400) et une deuxième surface latérale adjacente à une arête (404),
- une première réglette de contacts s'étendant le long de la première surface latérale pour l'injection de porteurs de charge d'un premier type dans la couche active (106) et
- une deuxième réglette de contacts s'étendant le long de la deuxième surface latérale pour l'injection de porteurs de charge d'un deuxième type dans la couche active (106),
dans lequel la première surface latérale (400) comprend une zone de retrait (700) adjacente à l'arête (404), et l'injection de porteurs de charge à partir de la première réglette de contacts est supprimée dans la zone de retrait (700), dans lequel la couche active (106) comprend une première surface principale et une deuxième surface principale, et une première borne de contact comportant la première réglette de contacts s'étend sur la première surface principale et une deuxième borne de contact (108) comportant la deuxième réglette de contacts s'étend sur la deuxième surface principale, **caractérisé en ce qu'**une couche de contact métallique (110) de la première borne de contact comprend une structure triangulaire dans une zone périphérique (902), dans lequel la couche de contact métallique est d'autant plus retirée de la surface latérale de la couche active (106) qu'elle se rapproche de la zone de retrait (700), de sorte que la première borne de contact comprend un profil de conductivité, et la conductivité diminue depuis un milieu de la première surface latérale (400) jusqu'à la zone de retrait (700).

2. Dispositif émetteur de lumière organique selon la revendication 1, dans lequel la première réglette de contacts est mise en contact électrique avec la première surface latérale (400) uniquement en dehors de la zone de retrait (700).

3. Dispositif émetteur de lumière organique selon l'une des revendications précédentes, dans lequel l'injection de porteurs de charge à partir de la première réglette de contacts est complètement supprimée dans la zone de retrait (700).

4. Dispositif émetteur de lumière organique selon l'une des revendications précédentes, dans lequel une fente est formée le long de la zone de retrait (700) entre la première réglette de contacts et la couche active (106).

5. Dispositif émetteur de lumière organique selon l'une des revendications précédentes, dans lequel la deuxième surface latérale comprend une deuxième zone de retrait (702) adjacente à l'arête (404), et l'injection de porteurs de charge à partir de la deuxième réglette de contacts est complètement supprimée dans la deuxième zone de retrait (702).

6. Dispositif émetteur de lumière organique selon l'une des revendications précédentes, dans lequel la première borne de contact comprend un oxyde conducteur, par exemple un oxyde d'étain.

7. Dispositif émetteur de lumière organique selon l'une des revendications précédentes, dans lequel la première borne de contact possède une première conductivité de surface et la deuxième borne de contact possède une deuxième conductivité de surface, et la première conductivité de surface et la deuxième conductivité de surface diffèrent au plus d'un facteur 10.

8. Dispositif émetteur de lumière organique selon l'une des revendications précédentes, lequel est conçu sous la forme d'une DELO transparente.

9. Dispositif émetteur de lumière organique selon l'une des revendications précédentes, lequel est conçu sous la forme d'une DELO bottom-emitter.
